# EUROPEAN PATENT APPLICATION

(11) **EP 3 258 547 A1**
(43) Date of publication of application: **20.12.2017**
(21) Application number: 16398006.3
(22) Date of filing: 17.06.2016
(51) Int. Cl.: H01R 13/66, H01R 13/05

(54) **ELECTRIC AUTOMOTIVE CONNECTOR WITH INCREASED MOUNTING SURFACE**

(71) Applicant: Tyco Electronics Componentes Electromecanicos Lda, 7005-797 Evora (PT); TE Connectivity Germany GmbH, 64625 Bensheim (DE)
(72) Inventor: Herlander, Francisco, 2405-034 Maceira LRA (PT); Einhorn, Joerg, 13591 Berlin (DE); Michael, Mathias, 68789 St. Leon-Rot (DE); Ngongang, Georges, 57050 Longevilles les Metz (FR)
(74) Representative: Grünecker Patent- und Rechtsanwälte PartG mbB

(57) **Abstract**

The invention relates to an electric automotive connector (1), in particular for a mini-ISO plug according to DIN 72552, comprising a base assembly (11) having at one side thereof a connector face (7) comprising at least one contact element (9) and having an interior side (17) opposite to the connector face (7). Electric automotive connector (1) of the art have the disadvantage of a limited mounting surface or mounting volume and consequently a limited number of electric component (27) that may be received in the electric automotive connector (1). This disadvantage of prior art solutions of electric automotive connector (1) is overcome by the invention by providing at least two circuit board sections (19) at the interior side (17) which extend away from the base assembly (11) and face each other, wherein each of the circuit board sections (19) comprises at least one electric component (27).

## Description

The invention relates to an electric automotive connector, in particular for a mini-ISO plug according to DIN 72552, comprising a base assembly having at one side thereof a connector face comprising at least one contact element and having an interior side opposite to the connector face.

Electric automotive connectors are known from the art and are available with standardized sizes and connection means, i.e. a plug face of the electric automotive connector having a standardized arrangement of contact pins, flat connectors or soldering pins.

In current automobiles in every new generation of cars, new functions with increased complexity are incorporated. This increased complexity puts pressure on the electric circuit that has to be included in various connectors.

An objective of the present invention is to provide an electric automotive connector having an increased mounting surface for receiving electric components without increasing its size prescribed by the applicable standard.

Another objective of the present invention is to reduce the overall size of the electric automotive connector, wherein the reduction of size refers to those dimensions of the electric automotive connector not specified by a minimum value covered or described by the applied standard (the reduction of size is not to be understood as, for instance, a reduction of the length of contact pins or flat connectors).

The previously mentioned electric automotive connector solves the above problems by providing at least two circuit board sections at the interior side which extend away from the base assembly and face each other, wherein each of the at least two circuit board sections comprises at least one electric component.

By providing two circuit board sections, the mounting surface may be increased up to twice the value of a single circuit board section. The at least two circuit board sections may be connected to the at least one contact element in a series or parallel. The contact board sections may preferentially extend perpendicularly away from the base assembly and the electric components may preferentially be arranged in the space between the at least two contact board sections.

In the following, different embodiments of the inventive electric automotive connector will be described by way of example, wherein each of the embodiments below is advantageous on its own. Technical features of the different embodiments may be arbitrarily combined or omitted if the technical effect achieved by the omitted technical feature is not relevant to the invention.

In a first embodiment of the inventive electric automotive connector, the at least one contact element is openly accessible from the connector face. Such an openly accessible contact element allows for easy mounting of the electric automotive connector, e.g. by plugging the electric automotive connector, more precisely the at least one contact element into a plug socket which is complementary to the connector face of the electric automotive connector.

Also, soldering pins for soldering the electric automotive connector to a circuit board are preferably openly accessible for easily mounting the electric automotive connector to the circuit board by soldering.

In a second embodiment of the electric automotive connector, at least one electrically conductive element is connected to the at least two circuit board sections. An electrically conductive element is advantageous for establishing an electric connection between the at least two circuit board sections.

The at least two circuit board sections may be galvanically isolated from each other except for the electric connection via the at least one electrically conductive element. An arbitrary number of electrically conductive elements may be provided and may electrically connect the at least two circuit board sections to each other. A plurality of electrically conductive elements may be used to provide a driving current and/or electrically coded signals from one circuit board section to different electric components on the second circuit board section. The electrically conductive elements may also be used to transmit control signals from one circuit board section to the other circuit board section.

In yet another embodiment of the electric automotive connector, an insulating element may connect the at least two circuit board sections. Such an insulating element may be applied to increase the mechanical stability of each of the at least two circuit board sections.

In a further embodiment of the electric automotive connector, the at least one electrically conductive element is arranged substantially parallel to the base assembly. Such an arrangement of the at least one electrically conductive element allows for optimal use of the space between the at least two circuit board sections, which would be decreased by an electrically conductive element arranged diagonally between the at least two circuit board sections. The at least one electrically conductive element may be embodied as an elongated contact member in the form of a pin or may be embodied as a plate arranged and mounted to the at least two circuit board sections.

In another embodiment of the inventive electric automotive connector, the at least two circuit board sections and the electrically conductive element comprise a U-shape.

A U-shape may be obtained if the at least one electrically conductive element is arranged at an end of the circuit board sections located distal to the base assembly. In such an embodiment, the circuit board sections may represent the legs of the U, whereas the at least one electrically conductive element represents the base of the U. As both legs of the U (the at least two circuit board sections) are connected to the base assembly, the overall assembly comprising the at least two circuit board sections and the at least one electrically conductive element has an increased stability and resistivity against vibrations.

In yet another embodiment of the inventive electric automotive connector, a further circuit board section is comprised, which further circuit board section is oriented essentially perpendicular to the at least two circuit board sections.

A further circuit board section may abut the at least two circuit board sections along an edge of the abutting circuit board section, whereas a contact line between the circuit board section may be larger than the contact area of a different electrically conductive element (e.g. a contact pin). Such an increased abutted area increases the stability of the overall assembly of the at least two circuit board sections and the further circuit board section.

The further circuit board section may be oriented parallel to the base assembly and may even more preferably be attached to the at least two circuit board sections at an end of the at least two circuit board sections facing away from the base assembly.

The further circuit board section may also comprise at least one electric component. The further circuit board section may be electrically connected to at least one of the at least two circuit board sections.

By increasing the number of circuit board sections, the available mounting surface may even be increased further.

In another embodiment of the inventive electric automotive connector, the further circuit board section and the at least two circuit board sections form a U-shape. As described above, a U-shape may increase the stability of the overall assembly comprising the at least two circuit board sections and the further circuit board section.

The legs of the U may be formed by the at least two circuit board sections and the base of the U may be formed by the further circuit board section.

In another embodiment of the inventive electric automotive connector, the circuit board sections are embodied on individual circuit boards. Arranging each circuit board section on an individual circuit board may facilitate mounting and unmounting of the electric automotive connector in case of a failure or malfunction, wherein maintenance may also be facilitated by circuit board sections embodied on individual circuit boards. Furthermore, individual circuit boards may be embodied such that a failure of one circuit board section may be compensated for by a second circuit board section which may temporarily replace the faulty circuit board section.

In another embodiment of the inventive electric automotive connector, the further circuit board section comprises at least one of a bearing member and bearing receptacle and at least one of the at least two circuit board sections comprises at least one of a bearing receptacle and a bearing member embodied essentially complementary to the at least one of a bearing member and bearing receptacle of the further circuit board section and in that the at least one bearing member engages in a form-fit with the corresponding bearing receptacle.

An inventive electric automotive connector according to another embodiment may be provided with a monolithic circuit board which comprises the at least two circuit board sections. Especially in the case of electric automotive connectors with a small footprint, a monolithically embodied circuit board may facilitate the mounting of the comprised circuit board sections onto the base assembly and/or into a housing of the electric automotive connector, as all circuit board sections may be mounted at once and do not need to be positioned to each other.

The monolithic circuit board may initially comprise the above-described U-shape.

In yet another embodiment of the inventive electric automotive connector, the monolithic circuit board comprises at least one angled section.

The at least one angled section may be preferentially comprised between at least one of the at least two circuit board sections and the further circuit board section. The angled section is preferably arranged at an edge of one circuit board section connecting an edge of another circuit board section. Several angled sections may be comprised in the electric automotive connector.

In a further embodiment of the inventive electric automotive connector, the at least one angled section is either bent, or folded, or both.

A bent angled section may comprise a bending radius, whereas a folded angled section comprises a relatively sharp kink of the angled section. The angled section may comprise any angle but is most preferably bent or folded by 90°.

Depending on the material of the angled section, only one of bending or folding may be possible for the corresponding angled section.

In another embodiment of the electric automotive connector, at least one angled section has a locally decreased thickness. A locally decreased thickness may allow for an easy bending of the angled section or may allow for folding the angled section, which may not be suited for folding or bending with an initial thickness.

If a circuit board is considered, bending or folding of such a circuit board is hardly possible with a circuit board of a common thickness of, for instance, several millimeters. Bending such a pristine circuit board would unavoidably result in fractures on the surfaces of the circuit board or even to a breaking of the circuit board if a certain bending angle is achieved.

The locally decreased thickness of the angled section may comprise an increased flexibility as compared to the pristine circuit board.

Reducing the thickness may be achieved by cutting the circuit board, chemically etching, or by shape cutting the angled region. Such techniques are to be understood only as exemplary methods for obtaining an angled section with a locally decreased thickness.

Preferentially, the progression from the initial thickness of the circuit board to the locally decreased thickness occurs in a smooth manner and not with a steep edge as a steep edge increases the danger of fractures and breaking of the circuit board.

In another embodiment of the electric automotive connector, in the region of locally decreased thickness, a circuit board is essentially reduced to-at-least one metallic layer. A remaining metallic layer has the advantage of being more flexible than a layer of the circuit board material of the corresponding thickness.

The at least one metallic layer preferentially comprises copper, which copper layer may be even more preferably the copper layer of the circuit board applied in the electric automotive connector. The at least one metallic layer may still be covered by a layer of the circuit board material wherein the layer thickness of the circuit board material is preferably below the layer thickness of the at least one metallic layer.

In yet another embodiment of the electric automotive connector, the base assembly and at least one of the at least two circuit boards are arranged to each other in a form-fit. A form-fit during the base assembly and at least one of the at least two circuit boards is advantageous as the available space, in particular the space of the housing of the electric automotive connector, may be used in an optimal way.

The base assembly and the at least one of the two circuit boards may even be arranged in a form-fit connection, i.e. they may be detachably locked to each other. The form-fit between the base assembly and the at least one circuit board may be engaged by a groove.

In the following, the inventive electric automotive connector will be described by way of example with reference to the accompanying figures. Technical features of the individual embodiments described below may be arbitrarily combined or omitted if the technical effect obtained by the omitted technical feature is not relevant to the invention. Same elements or elements with the same technical effect will be labeled with the same reference numerals.

In the figures:
- Fig. 1: shows a first embodiment of the inventive electric automotive connector in a perspective and side view;
- Fig. 2: shows a second embodiment of the inventive electric automotive connector in a perspective and side view;
- Fig. 3: shows a third embodiment of the inventive electric automotive connector in a perspective and side view; and
- Fig. 4: shows a fourth embodiment of the inventive electric automotive connector in a perspective and side view.

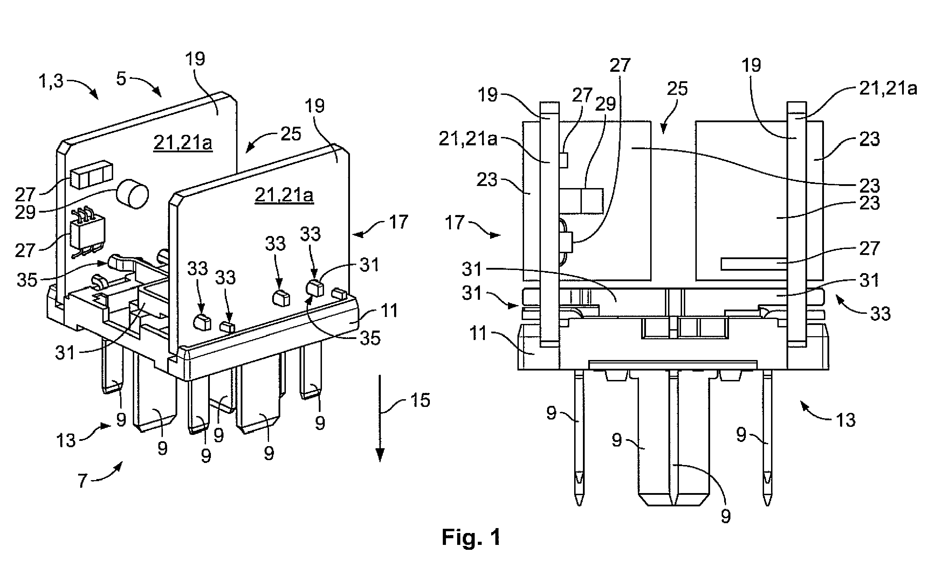

In Fig. 1, a first embodiment of the inventive electric automotive connector 1 is shown. The electric automotive connector 1 shown in Fig. 1 is embodied as a relay 3 in a plug-in form 5.

The plug-in form 5 is characterized by a connector face 7 which comprises a multitude of contact elements 9. The electric automotive connector 1 further comprises a base assembly 11 which receives the contact elements 9.

The contact elements 9 extend from the base assembly 11 to a connector side 13 in a connector direction 15. Along the connector direction 15 the electric automotive connector 1 may be plugged into a corresponding plug socket provided for instance in a car.

Opposite to the connector face 7, the electric automotive connector 1 comprises an interior side 17 on which two circuit board sections 19 are provided which extend away from the base assembly 11.

The two circuit board sections 19 are oriented essentially perpendicular to the base assembly 11 and parallel to each other. The two circuit board sections 19 are each embodied on a circuit board 21, wherein the circuit boards 21 shown in the embodiment of Fig. 1 are individual circuit boards 21 a.

Each of the individual circuit boards 21a defines a mounting volume 23 which faces towards a space 25 between the circuit boards 21 and a mounting volume 23 which faces away from said space 25. The mounting volumes 23 are indicated in Fig. 1 by rectangles.

Within the mounting volumes 23, each of the circuit board sections 19 may comprise at least one electric component 27 illustrated in Fig. 1 by two exemplary electric components 27. The electric automotive connector 1 may, however, comprise mechanic or electromechanical components 29 as well.

Fig. 1 further shows transmitting elements 31 which are located and/or attached to the interior side 17 of the base assembly 11 and which are either connected to or monolithically embodied with the contact elements 9. The transmitting elements 31 are mechanically and electrically connected to the individual circuit boards 21a via through hole technology 33, i.e. the transmitting elements 31 are inserted through holes 55 in the individual circuit boards 21 a and subsequently soldered to said individual circuit boards 21a. The transmitting elements 31 transmit electric signals and/or power supply voltages from the contact elements 9 to the electric components 27 or electromechanical components 29 arranged on the individual circuit boards 21a.

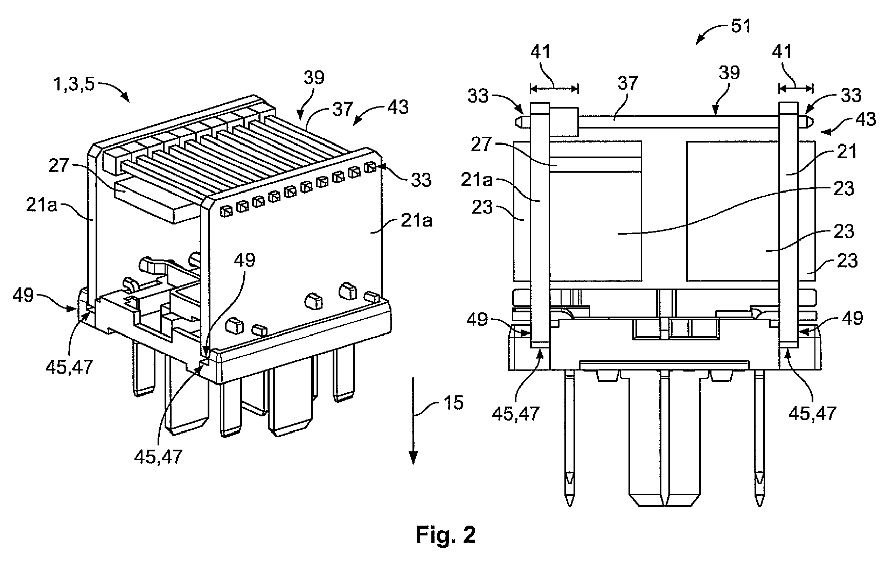

For reasons of visibility, the mechanic connection between the base assembly 11 and the circuit boards 21 will be explained with reference to Fig. 2.

Fig. 2 shows a second embodiment of the electric automotive connector 1, which is also embodied as a relay 3 in the plug-in form 5.

The basic assembly of the second embodiment shown in Fig. 2 is essentially the same as for the first embodiment of Fig. 1, whereas in the second embodiment a multitude of electrically conductive elements 37 (only one of the electrically conductive elements 37 is provided with a reference numeral) connect the two individual circuit boards 21 a.

The electrically conductive elements 37 are attached to the individual circuit boards 21a via through hole technology 33. An established electric connection 39 allows for transmission of electrically coded data and/or supply voltages from one individual circuit board 21a to another individual circuit board 21 a.

The electrically conductive elements 37 also mechanically stabilize the individual circuit boards 21 a by preventing or at least reducing vibrations of the individual circuit boards 21 a along a vibration direction 41 indicated by a double-headed arrow.

The individual circuit boards 21 a and the electrically conductive elements 37 are arranged in a U-shape 43.

Fig. 2 furthermore shows that the two individual circuit boards 21a are received in a form-fit member 45 arranged at the interior side 17 of the base assembly 11. The form-fit member 45 is embodied as a groove 47. The two individual circuit boards 21a are partially received within the two grooves 47 opening towards the interior side 17 such that each groove 47 engages in a form-fit 49 with the corresponding individual circuit board 21 a.

The individual circuit boards 21 a may be loosely received in the grooves 47, may be press-fit into the grooves 47 or may be mechanically clamped or fixed to the groove 47 by appropriate fixation means (e.g. a screw, which is not shown in Fig. 2).

The second embodiment of the inventive electric automotive connector 1 shown in Fig. 2 comprises similar mounting volumes 23 as the first embodiment of Fig. 1, whereas the dimension of the mounting volumes 23 in a direction opposite to the connector direction 15 is slightly reduced due to the electrically conductive elements 37.

The electrically conductive elements 37 of the second embodiment shown in Fig. 2, however, may protect electric components 27 from being accessed from an upper side 51.

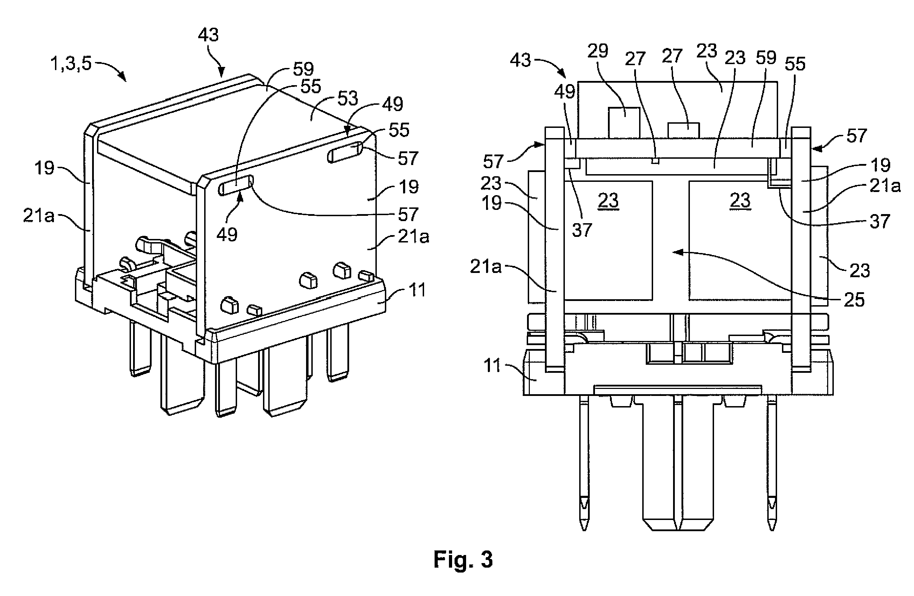

Fig. 3 shows a third embodiment of the inventive electric automotive connector 1 which is also embodied as a relay 3 in the plug-in form 5.

This third embodiment comprises a further circuit board section 53 which is attached to the two circuit board sections 19 by four bearing members 55, which extend away from the further circuit board section 53 and are received in bearing receptacles 57 embodied in the two individual circuit boards 21 a at a side thereof distal to the base assembly 11.

The bearing receptacles 57 and the bearing members 55 engage with each other in a form-fit 49, i.e. the bearing members 55 abut the interior of the bearing receptacles 57, which detachably receive the bearing members 55. The bearing members 55 and the bearing receptacles 57 are essentially complementary to each other.

In the embodiment of the electric automotive connector 1 shown in Fig. 3, the bearing members 55 do not extend in the space 25 or out of the bearing receptacles 57 of the individual circuit boards 21a.

The further circuit board section 53 is arranged on a further circuit board 59 which is oriented essentially perpendicular to the individual circuit boards 21 a and essentially parallel to the base assembly 11.

The further circuit board 59 defines additional mounting volumes 23 in which further electric 27 or electromagnetic components 29 may be mounted to the further circuit board 59.

The further circuit board 59 may be electrically connected to at least one of the individual circuit boards 21a by an electrically conductive element 37 which is exemplarily shown in Fig. 3 in the form of an angled electrically conductive element 37.

Also, in the third embodiment of the inventive electric automotive connector 1 shown in Fig. 3, the individual circuit boards 21 a and the further circuit board 59 form a U-shape 43.

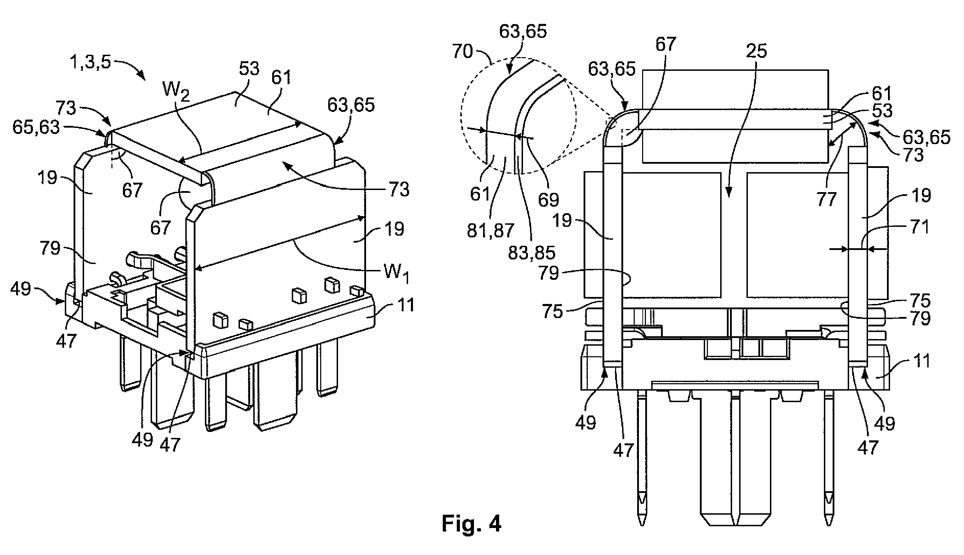

Fig. 4 shows a fourth embodiment of the inventive electric automotive connector 1, which is also embodied as a relay 3 in the plug-in form 5.

Contrary to the first three embodiments, this fourth embodiment does not comprise individual circuit boards 21 a, but is formed by a monolithic circuit board 61.

The monolithic circuit board 61 comprises two circuit board sections 19 which are essentially oriented perpendicular to the base assembly 11 and essentially parallel to each other, and a further circuit board section 53 which is essentially oriented perpendicular to the two circuit board sections 19 and essentially parallel to the base assembly 11.

The ends of the monolithic circuit board 61 are received in the grooves 47 of the base assembly 11 and are engaged in a form-fit 49 therewith.

Between each of the two circuit board sections 19 and the further circuit board section 53, an angled section 63 is comprised.

In the embodiment shown in Fig. 4 , the circuit board sections 19 have a CBS-width w₁ which is larger than a top-width w₂ of the further circuit board section 53. The angled sections 63 extend along the further circuit board sections 53 having the same top-width w₂.

The angled sections 63 of the embodiment shown in Fig. 4 are bent sections 65 but may also be folded sections (not shown) in possible different embodiments.

The bent sections 65 result in a bending angle 67 between each of the two circuit board sections 19 and the further circuit board section 53. The bending angle 67 is approximately a right angle of 90°.

The angled sections 63 comprise a decreased thickness 69 (shown in zoom 70), which is smaller than the circuit board thickness 71. This decreased thickness 69 results in an increased flexibility 73 of the angled sections 63.

The angled sections 63 are located at side walls 75 of the electric automotive connector 1 facing away from the space 25 in between the circuit board sections 19 and the further circuit board section 53. This solution has the advantage that a bending radius 77 of the angled sections 63 is larger than the bending radius 77 obtainable if the angled sections 63 are located at inner walls 79 of the electric automotive connector 1. An increased bending radius 77 reduces the risk of fractures and/or severe damage respectively to the angled sections 63.

In the zoom 70 of Fig. 4, the detailed structure of the angled section 63 is depicted. In the region of decreased thickness 69, the monolithic circuit board 61 is thinned such that a metallic layer 81 and a residual layer 83 of circuit board material 85 remain. The metallic layer is preferentially a copper layer 87.

Although an electric component 27 is only shown in Figs. 1 and 2, electric components 27 may also be comprised in the embodiments of Figs. 3 and 4. The technical features described in the first embodiment of the inventive electric automotive connector 1 may be found in the subsequently described embodiments of Figs. 2, 3 and 4 and have not been repeated for the sake of brevity.

The entire electric automotive connector 1 may be comprised in a connector housing, which is not shown in the figures but commonly applied for the electric automotive connectors 1 shown herein.

The footprint of the four embodiments shown in Figs. 1 to 4 is defined by the according standard used for the electric automotive connectors 1. The exemplary standard of the four embodiments shown is the mini ISO plug-in type standard for automotive relays 3. The arrangement and size of the contact elements 9 may be found in the German DIN standard DIN 72552.

The present disclosure is, however, not limited to this type of standard and it will be understood by those skilled in the art that various changes in form and details may be made therein without departing from the scope of the invention encompassed by the appended claims.

### REFERENCE NUMERALS

- 1: electric automotive connector
- 3: relay
- 5: plug-in form
- 7: connector face
- 9: contact element
- 11: base assembly
- 13: connector side
- 15: connector direction
- 17: interior side
- 19: circuit board section
- 21: circuit board
- 21a: individual circuit board
- 23: mounting volume
- 25: space
- 27: electric component
- 29: electromechanical component
- 31: transmitting element
- 33: through hole technology
- 35: hole
- 37: electrically conductive element
- 39: electric connection
- 41: vibration direction
- 43: U-shape
- 45: form-fit member
- 47: groove
- 49: form-fit
- 51: upper side
- 53: further circuit board section
- 55: bearing member
- 57: bearing receptacle
- 59: further circuit board
- 61: monolithic circuit board
- 63: angled section
- 65: bent section
- 69: decreased thickness
- 70: zoom
- 71: circuit board thickness
- 73: flexibility
- 75: side walls
- 77: bending radius
- 79: inner wall
- 81: metallic layer
- 83: residual layer
- 85: circuit board material
- 87: copper layer

- w₁: CBS-width
- w₂: top-width

## Claims

1. Electric automotive connector (1), in particular for a mini-ISO plug, comprising a base assembly (11) having at one side thereof a connector face (7) comprising at least one contact element (9) and having an interior side (17) opposite to the connector face (7), **characterized in that** at least two circuit board sections (19) are provided at the interior side (17) which extend away from the base assembly (11) and face each other, and **in that** each of the at least two circuit board sections (19) comprises at least one electric component (27).

2. Electric automotive connector (1) according to claim 1, **characterized in that** the at least one contact element (9) is openly accessible from the connector face (7).

3. Electric automotive connector (1) according to claim 1 or 2, **characterized in that** at least one electrically conductive element (37) is connected to the at least two circuit board sections (19).

4. Electric automotive connector (1) according to claim 3, **characterized in that** the at least one electrically conductive element (37) is arranged substantially parallel to the base assembly (11).

5. Electric automotive connector (1) according to claim 3 or 4, **characterized in that** the at least two circuit board sections (19) and the at least one electrically conductive element (37) comprise a U-shape (43).

6. Electric automotive connector (1) according to any one of claims 1 to 5, **characterized in that** a further circuit board section (53) is comprised, which further circuit board section (53) is oriented essentially perpendicular to the at least two circuit board sections (19).

7. Electric automotive connector (1) according to claim 6, **characterized in that** the further circuit board section (53) and the at least two circuit board sections (19) form a U-shape (43).

8. Electric automotive connector (1) according to any one of claims 1 to 7, **characterized in that** the at least two circuit board sections (19) are embodied on individual circuit boards (21 a).

9. Electric automotive connector (1) according to any one of claims 6 to 8, **characterized in that** the further circuit board section (53) comprises at least one of a bearing member (55) and bearing receptacle (57) and **in that** at least one of the at least two circuit board sections (19) comprises at least one of a bearing receptacle (57) and bearing member (55) embodied essentially complementary to the at least one of a bearing member (55) and bearing receptacle (57) of the further circuit board section (53), and **in that** the at least one bearing member (55) engages in a form-fit (49) with the corresponding bearing receptacle (57).

10. Electric automotive connector (1) according to any one of claims 1 to 9, **characterized in that** a monolithic circuit board (61) is provided which comprises the at least two circuit board sections (19).

11. Electric automotive connector (1) according to claim 10, **characterized in that** the monolithic circuit board (61) comprises at least one angled section (63).

12. Electric automotive connector (1) according to claim 11, **characterized in that** the at least one angled section (63) is at least one of bent and folded.

13. Electric automotive connector (1) according to claim 11 or 12, **characterized in that** the at least one angled section (63) has a locally decreased thickness (69).

14. Electric automotive connector (1) according to claim 13, **characterized in that**, in the region of locally decreased thickness (69), the monolithic circuit board (61) is essentially reduced to at least one metallic layer (81).

15. Electric automotive connector (1) according to any one of claims 1 to 14, **characterized in that** the base assembly (11) and at least one of the at least two circuit board sections (19) are arranged to each other in a form-fit (49).
